# EUROPEAN PATENT APPLICATION

(11) **EP 4 842 185 A1**
(43) Date of publication of application: **18.11.2026**
(21) Application number: 26171196.4
(22) Date of filing: 08.04.2026
(51) Int. Cl.: H10P 72/00

(54) **PROCESSING LIQUID SUPPLY DEVICE, SUBSTRATE PROCESSING APPARATUS, PROCESSING LIQUID SUPPLY METHOD AND SUBSTRATE PROCESSING METHOD**

(30) Priority: 15.04.2025 JP 2025066874
(71) Applicant: SCREEN Holdings Co., Ltd., Kyoto-shi, Kyoto 602-8585 (JP)
(72) Inventor: WATANABE, Tetsuya, Kyoto, 602-8585 (JP)
(74) Representative: Kilian Kilian & Partner mbB

(57) **Abstract**

A sending pipe connects one end portion of a heat exchanger that exchanges heat between a processing liquid a temperature control medium to an outlet of a chiller. A return pipe connects the other end portion of the heat exchanger to an outlet of the chiller. A bypass pipe connects a first portion in the sending pipe to a second portion in the return pipe. In a case in which a supply state of the temperature control medium supplied by the chiller is normal, the supply of the temperature control medium to the heat exchanger is maintained by opening a supply valve. In a case in which the supply state of the temperature control medium is abnormal, the supply of the temperature control medium to the heat exchanger is stopped by closing the supply valve.

## Description

### BACKGROUND

### Technical Field

The present disclosure relates to a processing liquid supply device, a substrate processing apparatus, a processing liquid supply method, and a substrate processing method, all of which are used for processing a substrate.

### Description of Related Art

A substrate processing apparatus is used to execute various processes on a substrate such as a semiconductor substrate, a substrate for a Flat Panel Display (FPD) that is used for a liquid crystal display device, an organic electroluminescence (EL) display device, or the like, a substrate for an optical disc, a substrate for a magnetic disc, a substrate for a magneto-optical disc, a substrate for a photomask, a ceramic substrate or a substrate for a solar cell. The processing liquid supply device supplies a processing liquid used for processing a substrate to the substrate processing apparatus. For example, JP 2021-52038 A describes a chemical liquid supply device that supplies a chemical liquid as the processing liquid.

### SUMMARY

A temperature of the processing liquid is appropriately regulated according to the contents of a substrate process. The temperature of the processing liquid can be regulated using a chiller system. For example, in the chiller system, a temperature control medium the temperature of which is regulated by a chiller circulates through a circulation pipe. A heat exchanger is provided in the circulation pipe. Therefore, the heat exchanger exchanges heat between the temperature control medium and the processing liquid, which regulates a temperature of the processing liquid.

In the chiller system, in a case in which the supply state of the temperature control medium becomes abnormal, circulation of the temperature control medium is stopped. This control prevents the substrate processing apparatus from being affected. However, the supply state of the temperature control medium is abnormal temporarily, and the abnormality is often resolved in a short period of time. Nevertheless, in a case in which the circulation of the temperature control medium is stopped every time the supply state of the temperature control medium becomes abnormal, a lot of manpower and time are required to restore the substrate processing apparatus after the abnormality is resolved.

An object of the present disclosure is to provide a processing liquid supply device, a substrate processing apparatus, a processing liquid supply method, and a substrate processing method, all of which enable easy restoration after resolution of an abnormal supply state of a temperature control medium.

A processing liquid supply device according to a first aspect of the present disclosure that is used together with a chiller and supplies a processing liquid for processing a substrate, with the chiller having an outlet and an inlet for a temperature control medium, includes a heat exchanger that has one end portion and another end portion, and exchanges heat between the processing liquid and the temperature control medium, a sending pipe that connects the outlet of the chiller to the one end portion of the heat exchanger, a return pipe that connects the inlet of the chiller to the another end portion of the heat exchanger, a bypass pipe that connects a first portion in the sending pipe to a second portion in the return pipe, with the first portion being located farther upstream than a portion connected to the heat exchanger, and with the second portion being located farther downstream than a portion connected to the heat exchanger, a supply valve, and a processor, wherein the processor, by executing a program, determines whether a supply state of the temperature control medium supplied by the chiller is normal, in a case in which the supply state of the temperature control medium is normal, maintains supply of the temperature control medium to the heat exchanger by opening the supply valve, and in a case in which the supply state of the temperature control medium is abnormal, stops the supply of the temperature control medium to the heat exchanger by closing the supply valve.

A substrate processing apparatus according to a second aspect of the present disclosure includes the above-mentioned processing liquid supply device, and a chamber in which the substrate is processed using the processing liquid supplied by the processing liquid supply device.

A processing liquid supply method according to a third aspect of the present disclosure of supplying a processing liquid for substrate processing a substrate, with the processing liquid supply method being used when a chiller having an outlet and inlet for a temperature control medium is used in the substrate processing, wherein a sending pipe connects, to the outlet of the chiller, one end portion of a heat exchanger that exchanges heat between the processing liquid and the temperature control medium, a return pipe connects another end portion of the heat exchanger to the inlet of the chiller, a bypass pipe connects a first portion in the sending pipe to a second portion in the return pipe, with the first portion being located farther upstream than a portion connected to the heat exchanger, and with the second portion being located farther downstream than a portion connected to the heat exchanger, and a processor, by executing a program, determines whether a supply state of the temperature control medium supplied by the chiller is normal, in a case in which the supply state of the temperature control medium is normal, maintains supply of the temperature control medium to the heat exchanger by opening a supply valve, and in a case in which the supply state of the temperature control medium is abnormal, stops the supply of the temperature control medium to the heat exchanger by closing the supply valve.

A substrate processing method according to a fourth aspect of the present disclosure includes the above-mentioned processing liquid supply method, wherein the substrate is processed in a chamber using the processing liquid that is supplied using the processing liquid supply method.

The present disclosure enables easy restoration after resolution of an abnormal supply state of a temperature control medium.

Other features, elements, characteristics, and advantages of the present disclosure will become more apparent from the following description of preferred embodiments of the present disclosure with reference to the attached drawings.

### BRIEF DESCRIPTION OF THE DRAWING

Fig. 1 is a schematic configuration diagram of a substrate processing apparatus according to one embodiment of the present disclosure;
Fig. 2 is a diagram showing the configuration of a chiller system;
Fig. 3 is a time chart showing one example of the work of the chiller system;
Fig. 4 is a block diagram showing the configuration of a controller;
Fig. 5 is a diagram showing functions of the controller of Fig. 4; and
Fig. 6 is a flowchart showing one example of a liquid supply process executed in the substrate processing apparatus.

### DETAILED DESCRIPTION

A substrate processing apparatus, a processing liquid supply device, a substrate processing method, and a processing liquid supply method according to one embodiment of the present disclosure will be described below with reference to the drawings. In the following description, a substrate refers to a substrate for a Flat Panel Display (FPD) that is used for a liquid crystal display device, an organic electroluminescence (EL) display device, or the like, a semiconductor substrate, a substrate for an optical disc, a substrate for a magnetic disc, a substrate for a magneto-optical disc, a substrate for a photomask, a ceramic substrate, a substrate for a solar cell, or the like.

### 1. Configuration of Substrate Processing Apparatus

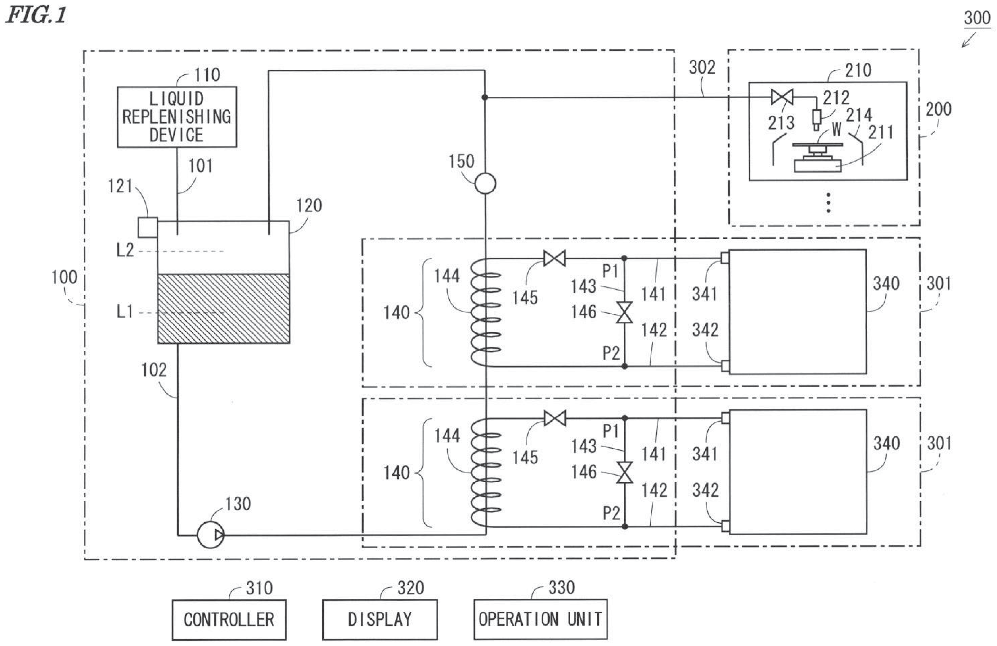

Fig. 1 is a schematic configuration diagram of the substrate processing apparatus according to the one embodiment of the present disclosure. As shown in Fig. 1, the substrate processing apparatus 300 includes a processing liquid supply device 100, a substrate processing section 200, a controller 310, a display 320, an operation unit 330, and one or more chillers 340. While regulating a temperature of a processing liquid within a predetermined range, the processing liquid supply device 100 supplies, to the substrate processing section 200, the processing liquid the temperature of which has been regulated. Detailed configuration of the processing liquid supply device 100 will be described below.

In the present embodiment, the processing liquid is a chemical liquid for etching a film formed on a substrate W, such as a silicon oxide film, a silicon nitride film, or a titanium nitride film. Examples of the chemical liquid include hydrofluoric acid (HF), buffered hydrofluoric acid (BHF), dilute hydrofluoric acid (DHF), a mixture of sulfuric acid and hydrogen peroxide (SPM), a mixture of ammonium water and hydrogen peroxide (SC1), a mixture of hydrochloric acid and hydrogen peroxide (SC2), diluted ammonium hydroxide (dNH₄OH) and tetramethylammonium hydroxide (TMAH). The range of temperature of the processing liquid regulated by the processing liquid supply device 100 is defined according to a type of the chemical liquid to be used and the contents of a process to be executed on the substrate W.

The substrate processing section 200 includes a plurality of chambers (e.g., twelve chambers). In Fig. 1, only one substrate processing section 200 is shown. In each chamber 210, a series of processes using the processing liquid is executed on a plurality of substrates W according to a processing recipe describing the contents of the process to be executed on the substrates W. In the present example, in each chamber 210, a spin chuck 211, a nozzle 212, an open-close valve 213, and a cup 214 are provided. The spin chuck 211 is configured to be capable of holding the substrate W to be processed. Further, the spin chuck 211 is driven by a driving device (not shown) (an electric motor, for example) to rotate while holding the substrate W. Thus, the substrate W held by the spin chuck 211 rotates.

When the open-close valve 213 is in an open state, the nozzle 212 discharges, to the substrate W held and rotated by the spin chuck 211, part of the processing liquid supplied by the processing liquid supply device 100. Thus, an obverse surface (upper surface in the present example) of the substrate W is processed. The cup 214 is provided so as to surround the substrate W held by the spin chuck 211, and receives the processing liquid splashing from the substrate W while the substrate W is being processed. The processing liquid received by the cup 214 is sent to a drainage facility provided outside of the substrate processing apparatus 300, for example. Note that at least part of the processing liquid received by the cup 214 may be returned to the processing liquid supply device 100.

The controller 310 controls the work of each component of the processing liquid supply device 100, the substrate processing section 200, and the chiller 340. Details of the controller 310 will be described below. The display 320 is formed of a liquid crystal display device or an organic electroluminescence (EL) display device, for example. The display 320 is capable of displaying a temperature, a flow rate, or the like of the processing liquid or a temperature control medium. Further, when a warning signal, described below, is being output, the display 320 can display a notification in regard to the warning signal. The operation unit 330 includes a keyboard and a pointing device, for example, and is configured to be operable by a user. The user can input various information to the substrate processing apparatus 300 by operating the operation unit 330.

In the present example, two chillers 340 are provided in the substrate processing apparatus 300. While regulating a temperature of the liquid temperature control medium (pure water in the present example) to a predetermined temperature, each chiller 340 stores the temperature control medium the temperature of which has been regulated. The temperature control medium stored by each chiller 340 is used to regulate a temperature of the processing liquid supplied from the processing liquid supply device 100 to the substrate processing section 200. Details of a chiller system 301 including the chiller 340 will be described below.

### 2. Processing Liquid Supply Device

As shown in Fig. 1, the processing liquid supply device 100 includes a replenishing pipe 101, a circulation pipe 102, a liquid replenishing device 110, a storage tank 120, a pump 130, one or more temperature regulators 140, and a temperature sensor 150. The substrate processing apparatus 300 according to the present embodiment is provided in a factory, for example. In the factory, a supply source for the processing liquid used for processing the substrate W is provided as a utility facility used for the substrate processing apparatus 300.

The liquid replenishing device 110 includes fluid-related elements such as a pipe, a joint, and a valve, and is connected to the supply source (not shown) for the processing liquid. The liquid replenishing device 110 may include a pump as part of the fluid-related elements. An upstream end of the replenishing pipe 101 is connected to the liquid replenishing device 110. The downstream end of the replenishing pipe 101 is arranged in the storage tank 120. The liquid replenishing device 110 replenishes the storage tank 120 with a processing liquid (new processing liquid) of a supply source (not shown) via the replenishing pipe 101.

The storage tank 120 stores a certain amount of the processing liquid. A liquid level sensor 121 is attached to the storage tank 120. The liquid level sensor 121 detects a liquid level (height of a liquid surface) of the processing liquid stored in the storage tank 120. Further, the liquid level sensor 121 outputs a liquid level signal indicating the detected liquid level to the controller 310. As the liquid level sensor 121, a capacitance-type liquid level sensor, an optical-type liquid level sensor, or an ultrasonic-type liquid level sensor can be used, for example.

In the storage tank 120, a lower limit level L1 and a prescribed level L2 are set. The lower limit level L1 corresponds to an amount of the processing liquid considered to be minimally required for supplying the processing liquid to the substrate processing section 200. The prescribed level L2 is higher than the lower limit level L1, corresponds to an amount of the processing liquid considered to be sufficient for supplying the processing liquid to the substrate processing section 200, and corresponds to an amount of the processing liquid considered not to overflow from the storage tank 120. The storage tank 120 is suitably replenished by the liquid replenishing device 110 with the processing liquid such that the liquid level is equal to or higher than the lower limit level L1 and equal to or lower than the prescribed level L2.

An upstream end of the circulation pipe 102 is connected to a bottom portion of the storage tank 120. A downstream end of the circulation pipe 102 is connected to an upper portion of the storage tank 120. In the circulation pipe 102, the pump 130, the one or more temperature regulators 140, and the temperature sensor 150 are arranged in this order from an upstream position to a downstream position. The pump 130 sucks the processing liquid stored in the storage tank 120, and pumps the sucked processing liquid toward the downstream end of the circulation pipe 102.

The one or more temperature regulators 140 respectively correspond to the one or more chillers 340. The temperature regulator 140 and the chiller 340 corresponding to the temperature regulator 140 form the chiller system 301. As described above, in the present example, since two chillers 340 are provided in the substrate processing apparatus 300, the processing liquid supply device 100 includes two temperature regulators 140. That is, in the present example, two chiller systems 301 are provided in the substrate processing apparatus 300. In each chiller system 301, the temperature regulator 140 exchanges heat between the temperature control medium stored in the chiller 340 and the processing liquid flowing through the circulation pipe 102. Thus, the temperature of the processing liquid is regulated to a predetermined temperature.

The temperature sensor 150 detects a temperature of the processing liquid flowing through the circulation pipe 102. Further, the temperature sensor 150 outputs a temperature signal indicating the detected temperature of the processing liquid to the controller 310. While the temperature sensor 150 is provided in a portion of the circulation pipe 102 further downstream than the temperature regulator 140 located at a most downstream position in the present example, the embodiment is not limited to this. The temperature sensor 150 may be provided in another portion of the circulation pipe 102.

A plurality of chamber pipes 302 are respectively connected to a plurality of portions of the circulation pipe 102 further downstream than the temperature regulator 140 located at the most downstream position. The plurality of chamber pipes 302 respectively correspond to the plurality of chambers 210 of the substrate processing section 200. Each chamber pipe 302 connects a portion of the circulation pipe 102 to a nozzle 212 of the corresponding chamber 210. In each chamber pipe 302, the open-close valve 213 of the corresponding chamber 210 is provided. By switching the open-close states of the plurality of valves, part of the processing liquid flowing through the circulation pipe 102 is selectively guided to the nozzle 212 of any one of the plurality of chambers 210.

### 3. Chiller System

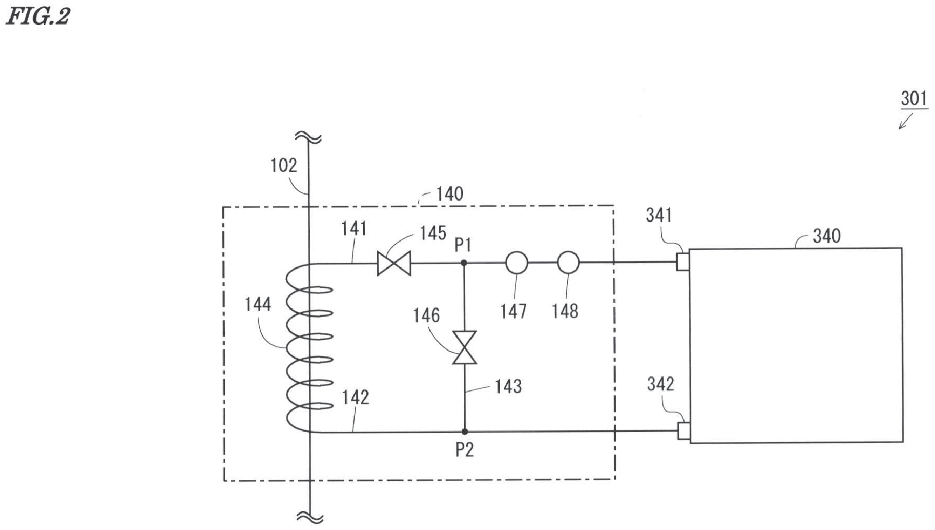

As described above, the chiller system 301 is formed of the temperature regulator 140 of the processing liquid supply device 100, and the chiller 340. Fig. 2 is a diagram showing the configuration of the chiller system 301. As shown in Fig. 2, the chiller 340 includes an outlet 341 and an inlet 342. The temperature control medium stored in the chiller 340 is sent out from the outlet 341. The temperature control medium that has been sent out from the outlet 341 is sent into the chiller 340 from the inlet 342.

The temperature regulator 140 includes a sending pipe 141, a return pipe 142, a bypass pipe 143, a heat exchanger 144, a supply valve 145, a bypass valve 146, a temperature sensor 147, and a flow-rate sensor 148. The sending pipe 141 connects one end portion of the heat exchanger 144 to the outlet 341 of the chiller 340. The return pipe 142 connects the other end portion of the heat exchanger 144 to the inlet 342 of the chiller 340. The bypass pipe 143 connects a portion P1 of the sending pipe 141 to a portion P2 of the return pipe 142.

The heat exchanger 144 is arranged while being thermally in contact with the circulation pipe 102. In the example of Fig. 2, the heat exchanger 144 has a spiral shape, and is wound around the circulation pipe 102 while being in contact with the circulation pipe 102. The supply valve 145 is an open-close valve, and is provided in a portion of the sending pipe 141 located farther downstream than the portion P1. The bypass valve 146 is an open-close valve, and is provided in the bypass pipe 143.

The temperature sensor 147 measures a temperature of the temperature control medium supplied by the chiller 340. The flow-rate sensor 148 measures a flow rate of the temperature control medium supplied by the chiller 340. While the temperature sensor 147 and the flow-rate sensor 148 are provided in portions of the sending pipe 141 located farther upstream than the portion P1 in the present example, the embodiment is not limited to this. One or both of the temperature sensor 147 and the flow-rate sensor 148 may be provided in a portion of the return pipe 142 located farther downstream than the portion P2, for example. Measurement results provided by the temperature sensor 147 and the flow-rate sensor 148 are provided to the controller 310 of Fig. 1.

By acquiring the measurement results provided by the temperature sensor 147 and the flow-rate sensor 14, the controller 310 monitors the supply state (a temperature or a flow rate, for example) of the temperature control medium supplied by the chiller 340, and determines whether the supply state of the temperature control medium is normal. In a case in which the supply state of the temperature control medium is normal, the controller 310 sets the output of the warning signal to a non-output state (OFF state). On the other hand, in a case in which the supply state of the temperature control medium is abnormal, the controller 310 sets the output of the warning signal to an output state (ON state). Further, the controller 310 controls the work of the chiller system 301 by switching the open-close states of the supply valve 145 and the open-close states of the bypass valve 146 in accordance with whether the output of the warning signal is set to the OFF state or the ON state.

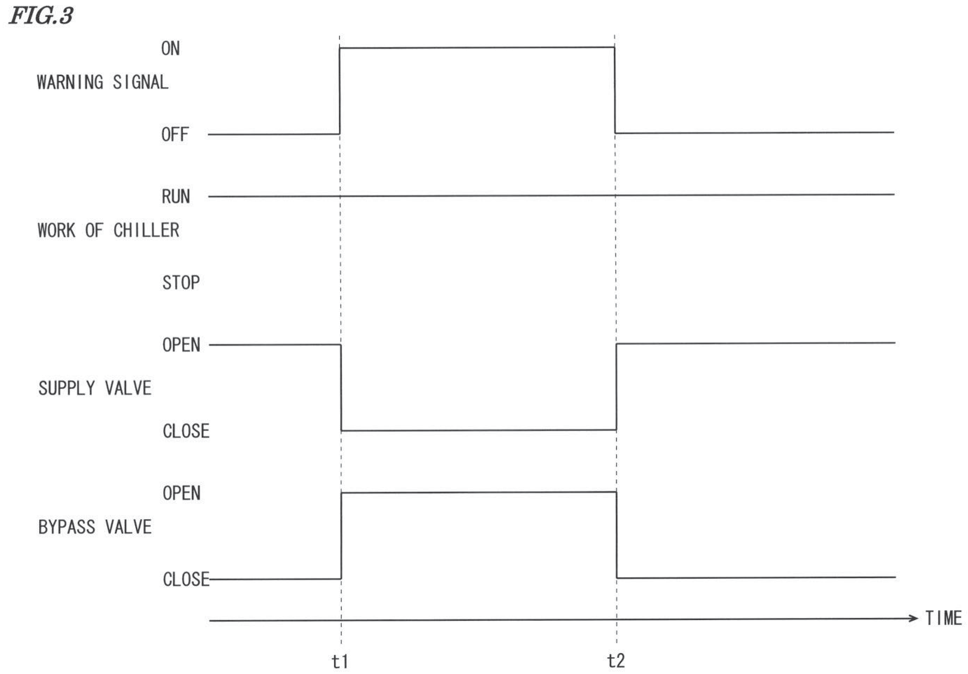

Fig. 3 is a time chart showing one example of the work of the chiller system 301. As shown in Fig. 3, during a period in which the output of the warning signal is set to the OFF state (the period before a point t1 in time and the period after a point t2 in time), the supply valve 145 is opened, and the bypass valve 146 is closed. In this case, because the chiller 340 is in a running state, the temperature control medium is sent out from the outlet 341, and flows through the heat exchanger 144 via the sending pipe 141. The temperature control medium that have flowed through the heat exchanger 144 is sent into the chiller 340 from the inlet 342 via the return pipe 142. Thus, the temperature control medium circulates via the heat exchanger 144. As the temperature control medium flows through the heat exchanger 144, heat is exchanged between the processing liquid flowing through the circulation pipe 102 and the temperature control medium.

On the other hand, during a period in which the output of the warning signal is set to the ON state (the period between the points t1 and t2 in time), the supply valve 145 is closed, and the bypass valve 146 is opened. Even in this case, the chiller 340 is not stopped and continues to run. Therefore, the temperature control medium is sent out from the outlet 341 and flows through the bypass pipe 143 via the sending pipe 141. The temperature control medium that has flowed through the bypass pipe 143 is sent into the chiller 340 from the inlet 342 via the return pipe 142. Thus, the temperature control medium circulates without passing through the heat exchanger 144.

### 4. Controller

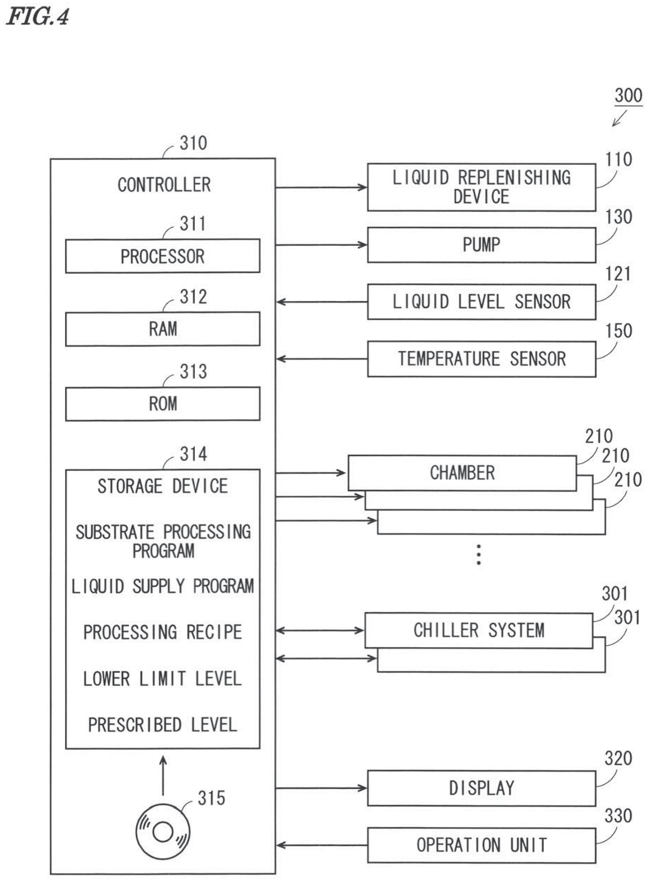

Fig. 4 is a block diagram showing the configuration of the controller 310. As shown in Fig. 4, the controller 310 includes a processor 311, a Random Access Memory (RAM) 312, a Read Only Memory (ROM) 313, and a storage device 314. The processor 311 includes a processor such as a central processing unit (CPU), a micro processing unit (MPU), a graphics processing unit (GPU), or a digital signal processor (DSP). The processor 311 may include a combination of two or more processors described above, or may include a field-programmable gate array (FPGA) or an application specific integrated circuit (ASIC).

The RAM 312 is used as a work area for the processor 311. A system program is stored in the ROM 313. The storage device 314 includes a storage medium such as a hard disc or a semiconductor memory, and stores a substrate processing program for executing a process on the substrate in the substrate processing section 200 and a liquid supply program for supplying the processing liquid to the plurality of chambers 210 in the processing liquid supply device 100. Further, the storage device 314 may store a plurality of processing recipes. Further, the storage device 314 may store the lower limit level L1 and the prescribed level L2 that are set in the storage tank 120 of Fig. 1.

The substrate processing program and the liquid supply program may be provided in the state of being stored in an external storage medium 315 such as a computer-readable SD memory card or a computer readable CD-ROM, and may be installed in the ROM 313 or the storage device 314. Alternatively, the substrate processing program and the liquid supply program may be distributed from a server outside of the substrate processing apparatus 300 via a communication network and installed in the ROM 313 or the storage device 314.

By execution of the liquid supply program by the processor 311, a necessary amount of the processing liquid is supplied from the processing liquid supply device 100 to the substrate processing section 200. Further, by execution of the substrate processing program by the processor 311, the work of each component of the substrate processing section 200 is controlled, and the substrate is processed using the processing liquid in each of the plurality of chambers 210. When the substrate processing program and the liquid supply program are executed, the controller 310 acquires measurement results provided by the liquid level sensor 121 and the temperature sensor 150, and controls the works of the liquid replenishing device 110, the pump 130, each chamber 210, and each chiller system 301.

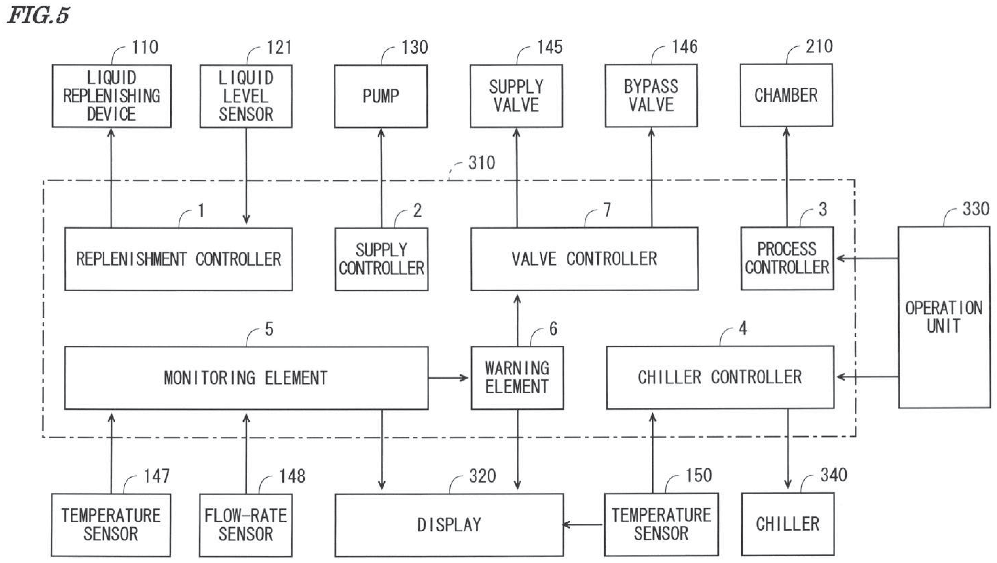

Fig. 5 is a diagram showing the functions of the controller 310 of Fig. 4. As shown in Fig. 5, the functions include a replenishment controller 1, a supply controller 2, a process controller 3, a chiller controller 4, a monitoring element 5, a warning element 6, and a valve controller 7. The functions of the controller 310 are implemented by execution of the liquid supply program and the substrate processing program by the processor 311. Part or all of the functions of the controller 310 may be realized by hardware such as an electronic circuit.

The replenishment controller 1 controls the work of the liquid replenishing device 110 based on a liquid level of the processing liquid in the storage tank 120 of Fig. 1 detected by the liquid level sensor 121. Thus, the storage tank 120 is suitably replenished by the liquid replenishing device 110 with the processing liquid such that the liquid level of the processing liquid in the storage tank 120 is equal to or higher than the lower limit level L1 and equal to or lower than the prescribed level L2. The supply controller 2 controls the work of the pump 130 such that the processing liquid circulates through the circulation pipe 102 of Fig. 1 at a predetermined flow rate.

The process controller 3 controls the works of the spin chuck 211 and the open-close valve 213 of Fig. 1 of each chamber 210 such that the substrate W is processed in accordance with a processing recipe designated by the user. By operating the operation unit 330, the user can designate a desired processing recipe from among the plurality of processing recipes stored in the storage device 314 of Fig. 4. The chiller controller 4 controls the work of each chiller 340 based on a temperature of the processing liquid detected by the temperature sensor 150 to bring the temperature of the processing liquid to a temperature described in the processing recipe. The display 320 can display the temperature of the processing liquid detected by the temperature sensor 150.

The monitoring element 5 acquires the measurement results of the temperature sensor 147 and the flow-rate sensor 148 corresponding to each chiller 340, and determines whether the supply state of the temperature control medium is normal. In the present example, in a case in which the temperature detected by the temperature sensor 147 is within a predetermined temperature range, and the flow rate detected by the flow-rate sensor 148 is within a predetermined flow-rate range, it is determined that the supply state of the temperature control medium is normal. In a case in which the temperature detected by the temperature sensor 147 is not within the predetermined temperature range or the flow rate detected by the flow-rate sensor 148 is not within the predetermined flow-rate range, it is determined that the supply state of the temperature control medium is abnormal. The display 320 can display the supply state (temperature or flow rate), which is monitored by the monitoring element 5, of the temperature control medium supplied by each chiller 340.

In a case in which the monitoring element 5 determines that the supply state of the temperature control medium is normal, the warning element 6 sets the output of the warning signal to the OFF state. Further, in a case in which the monitoring element 5 determines that the supply state of the temperature control medium is abnormal, the warning element 6 sets the output of the warning signal to the ON state. The display 320 can display whether the output of the warning signal is set to the OFF state or the ON state.

When the output of the warning signal is set to the OFF state by the warning element 6, the valve controller 7 opens the supply valve 145 and closes the bypass valve 146. In this case, the temperature control medium circulates while exchanging heat with the processing liquid in order to bring the processing liquid to an arbitrary temperature. When the output of the warning signal is set to the ON state by the warning element 6, the valve controller 7 closes the supply valve 145 and opens the bypass valve 146. Even in this case, the temperature control medium continues to circulate.

### 5. Liquid Supply Process

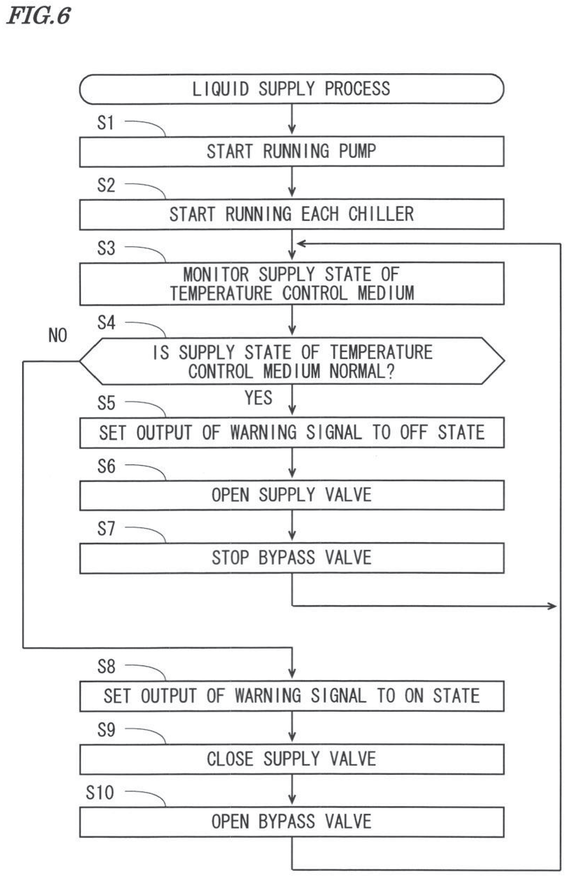

Fig. 6 is a flowchart showing one example of a liquid supply process executed in the substrate processing apparatus 300. The liquid supply process is executed when the processor 311 of the controller 310 executes a liquid supply program stored in the storage device 314 or the like while utilizing the RAM 312 as a work area. The liquid supply process will be described below with reference to the controller 310 of Fig. 5.

First, the supply controller 2 starts running the pump 130 such that the processing liquid circulates through the circulation pipe 102 of Fig. 1 at a predetermined flow rate (step S1). Further, the chiller controller 4 starts running each chiller 340 based on a temperature of the processing liquid detected by the temperature sensor 150 to bring the temperature of the processing liquid to a predetermined temperature (step S2). Either the step S1 or the step S2 may be executed first, or the step S1 and the step S2 may be executed at the same time. The subsequent processes are executed by each chiller 340.

The monitoring element 5 monitors the supply state of the temperature control medium by acquiring the measurement results provided by the temperature sensor 147 and the flow-rate sensor 148 (step S3). Next, the monitoring element 5 determines whether the supply state of the temperature control medium monitored in the step S3 is normal (step S4). In a case in which the supply state of the temperature control medium is normal, the warning element 6 sets the output of the warning signal to the OFF state (step S5). Subsequently, the valve controller 7 opens the supply valve 145 (step S6). Further, the valve controller 7 closes the bypass valve 146 (step S7). Either the step S6 or the step S7 may be executed first, or the step S6 and the step S7 may be executed at the same time. After that, the process returns to the step S3.

In the step S3, in a case in which the supply state of the temperature control medium is abnormal, the warning element 6 sets the output of the warning signal to the ON state (step S8). Subsequently, the valve controller 7 closes the supply valve 145 (step S9). Further, the valve controller 7 opens the bypass valve 146 (step S10). Either the step S9 or the step S10 may be executed first, or the step S9 and the step S10 may be executed at the same time. After that, the process returns to the step S3.

### 6. Effects

In the processing liquid supply device 100 according to the present embodiment, in a case in which the supply state of the temperature control medium is normal, the temperature control medium is sent from the outlet 341 of the chiller 340 to the one end portion of the heat exchanger 144 via the sending pipe 141 because the supply valve 145 is opened. The temperature control medium that has been sent to the heat exchanger 144 returns to the inlet 342 of the chiller 340 via the return pipe 142 from the other end portion of the heat exchanger 144. Therefore, the temperature control medium circulates through the sending pipe 141, the heat exchanger 144, and the return pipe 142, which maintains the supply of the temperature control medium to the heat exchanger 144. This causes heat exchange between the processing liquid for processing the substrate W and the temperature control medium.

On the other hand, in a case in which the supply state of the temperature control medium is abnormal, the supply of the temperature control medium to the heat exchanger 144 is stopped because the supply valve 145 is closed. Even in this case, the portion P1 of the sending pipe 141 is connected to the portion P2 of the return pipe 142 by the bypass pipe 143. This causes the temperature control medium to continue circulating through the sending pipe 141, the bypass pipe 143, and the return pipe 142 since the chiller 340 continues to run without stopping. Thus, it is not necessary to restore the chiller 340 after the abnormality is resolved, and heat exchange between the processing liquid and the temperature control medium can be easily resumed by opening the supply valve 145. This enables easy restoration after resolution of the abnormality of the supply state of the temperature control medium.

The supply valve 145 is provided in a portion of the sending pipe 141 farther downstream than the portion P1. In this case, the pressure of the temperature control medium sent from the chiller 340 to the heat exchanger 144 is reduced by the supply valve 145. This prevents the heat exchanger 144 from being damaged even in a case in which the heat exchanger 144 is used for a long period of time.

The bypass pipe 146 is provided in the bypass pipe 143. In a case in which the supply state of the temperature control medium is normal, the bypass valve 146 is closed. In a case in which the supply state of the temperature control medium is abnormal, the bypass valve 146 is opened. With this configuration, in a case in which the supply state of the temperature control medium is normal, the temperature control medium does not flow through the bypass pipe 143. Thus, the temperature control medium can be efficiently sent to the heat exchanger 144.

The monitoring element 5 acquires, from the temperature sensor 147 and the flow-rate sensor 148, a temperature and a flow rate of the temperature control medium supplied by the chiller 340. Whether the supply state of the temperature control medium is normal is determined based on the acquired temperature and the acquired flow rate of the temperature control medium. In this case, whether the supply state of the temperature control medium is normal can be easily determined based on the temperature of the temperature control medium. Further, in a case in which the supply state of the temperature control medium is abnormal, the warning element 6 of the processor 311 outputs a warning signal indicating an abnormality of the supply state of the temperature control medium. In this case, the user can easily identify whether the supply state of the temperature control medium is abnormal.

### 7. Other Embodiments

(1) While the supply valve 145 is provided in the portion of the sending pipe 141 located farther downstream than the portion P1 in the above-mentioned embodiment, the embodiment is not limited to this. The supply valve 145 may be provided in a portion of the return pipe 142 located farther upstream than the portion P2.
(2) While the bypass valve 146 is provided in the bypass pipe 143 in the above-mentioned embodiment, the embodiment is not limited to this. The bypass valve 146 does not have to be provided in the bypass pipe 143.
(3) While the temperature regulator 140 includes the temperature sensor 147 and the flow-rate sensor 148 in the above-mentioned embodiment, the embodiment is not limited to this. A general-purpose temperature sensor and a general-purpose flow-rate sensor can respectively detect a temperature and a flow rate of the temperature control medium. Therefore, in a case in which the general-purpose temperature sensor is provided, the temperature regulator 140 does not have to include the temperature sensor 147. Similarly, in a case in which the general-purpose flow-rate sensor is provided, the temperature regulator 140 does not have to include the flow-rate sensor 148.
(4) While, in the above-mentioned embodiment, whether the supply state of the temperature control medium is normal is determined based on both a temperature and a flow rate of the temperature control medium, the embodiment is not limited to this. Whether the supply state of the temperature control medium is normal may be determined based on either the temperature or the flow rate of the temperature control medium. In a case in which the temperature of the temperature control medium is not used for the determination, the temperature regulator 140 does not have to include the temperature sensor 147. Similarly, in a case in which the flow rate of the temperature control medium is not used for the determination, the temperature regulator 140 does not have to include the flow-rate sensor 148.
(5) While, in the above-mentioned embodiment, the warning signal is output in a case in which the supply state of the temperature control medium is abnormal, the embodiment is not limited to this. Even in a case in which the supply state of the temperature control medium is abnormal, the warning signal does not have to be output. In this case, the controller 310 does not include the warning element 6. Furthermore, the steps S5 and S8 are not executed in the liquid supply process.
(6) While the processing liquid is the chemical liquid for etching the film of the substrate W in the above-mentioned embodiment, the embodiment is not limited to this. For example, the processing liquid may be a rinse liquid for rinsing the upper surface of the substrate W. Alternatively, the processing liquid may be a replacement liquid for removing a chemical liquid remaining on the upper surface of the substrate W.
(7) While a pipe such as the replenishing pipe 101, the circulation pipe 102, the sending pipe 141, the return pipe 142, the bypass pipe 143, or the chamber pipe 302 is formed of a single pipe member in the above-mentioned embodiment, the embodiment is not limited to this. The pipe may be formed of a plurality of pipe members, and one or more joints connecting the plurality of pipe members to one another, and the like.
(8) While the substrate processing apparatus 300 includes the two chiller systems 301 in the above-mentioned embodiment, the embodiment is not limited to this. The substrate processing apparatus 300 may include one chiller system 301 or three or more chiller systems 301.

### 8. Correspondences Between Constituent Elements in Claims and Parts in Preferred Embodiments

In the following paragraphs, non-limiting examples of correspondences between various elements recited in the claims below and those described above with respect to various preferred embodiments of the present disclosure are explained. As each of various elements recited in the claims, various other elements having configurations or functions described in the claims can be also used.

In the above-mentioned embodiment, the outlet 341 is an example of an outlet, the inlet 342 is an example of an inlet, the chiller 340 is an example of a chiller, the substrate W is an example of a substrate, and the processing liquid supply device 100 is an example of a processing liquid supply device. The heat exchanger 144 is an example of a heat exchanger, the sending pipe 141 is an example of a sending pipe, the return pipe 142 is an example of a return pipe, the portion P1 is an example of a first portion, the portion P2 is an example of a second portion, and the bypass pipe 143 is an example of a bypass pipe. The supply valve 145 is an example of a supply valve, the processor 311 is an example of a processor, the bypass valve 146 is an example of a bypass valve, the chamber 210 is an example of a chamber, and the substrate processing apparatus 300 is an example of a substrate processing apparatus.

### 9. Overview of Embodiments

A processing liquid supply device according to item 1 that is used together with a chiller and supplies a processing liquid for processing a substrate, with the chiller having an outlet and an inlet for a temperature control medium, includes a heat exchanger that has one end portion and another end portion, and exchanges heat between the processing liquid and the temperature control medium, a sending pipe that connects the outlet of the chiller to the one end portion of the heat exchanger, a return pipe that connects the inlet of the chiller to the another end portion of the heat exchanger, a bypass pipe that connects a first portion in the sending pipe to a second portion in the return pipe, with the first portion being located farther upstream than a portion connected to the heat exchanger, and with the second portion being located farther downstream than a portion connected to the heat exchanger, a supply valve, and a processor, wherein the processor, by executing a program, determines whether a supply state of the temperature control medium supplied by the chiller is normal, in a case in which the supply state of the temperature control medium is normal, maintains supply of the temperature control medium to the heat exchanger by opening the supply valve, and in a case in which the supply state of the temperature control medium is abnormal, stops the supply of the temperature control medium to the heat exchanger by closing the supply valve.

In this processing liquid supply device, in a case in which the supply state of the temperature control medium is normal, the temperature control medium is sent from the outlet of the chiller to the one end portion of the heat exchanger via the sending pipe by opening the supply valve. The temperature control medium that has been sent to the heat exchanger returns from the other end portion of the heat exchanger to the inlet of the chiller via the return pipe. Therefore, the temperature control medium circulates through the sending pipe, the heat exchanger, and the return pipe, which maintains the supply of the temperature control medium to the heat exchanger. This causes the heat exchange between the processing liquid for processing the substrate, and the temperature control medium.

On the other hand, in a case in which the supply state of the temperature control medium is abnormal, the supply of the temperature control medium to the heat exchanger is stopped by closing the supply valve. Even in this case, the first portion in the sending pipe is connected to the second portion of the return pipe by the bypass pipe. The chiller continues to run without stopping, which causes the temperature control medium to continue circulating through the sending pipe, the bypass pipe, and the return pipe. Therefore, it is not necessary to restore the chiller after the abnormality is resolved, and heat exchange between the processing liquid and the temperature control medium can be easily resumed by opening the supply valve. This enables easy restoration after resolution of the abnormality of the supply state of the temperature control medium.

(Item 2) The processing liquid supply device according to item 1, wherein the supply valve may be provided in a portion farther downstream than the first portion in the sending pipe.

In this case, the pressure of the temperature control medium sent from the chiller to the heat exchanger is reduced by the supply valve. This prevents the heat exchanger from being damaged even in a case in which the heat exchanger is used for a long period of time.

(Item 3) The processing liquid supply device according to item 1 or 2, may further include a bypass valve provided in the bypass pipe, wherein the processor, by executing the program, in a case in which the supply state of the temperature control medium is normal, may close the bypass valve, and in a case in which the supply state of the temperature control medium is abnormal, may open the bypass valve.

With this configuration, in a case in which the supply state of the temperature control medium is normal, the temperature control medium does not flow through the bypass pipe. This enables the temperature control medium to be efficiently sent to the heat exchanger.

(Item 4) The processing liquid supply device according to any one of items 1 to 3, wherein the processor, by executing the program, may acquire, from a temperature sensor, a temperature of the temperature control medium supplied by the chiller, and may determine, based on the acquired temperature of the temperature control medium, whether the supply state of the temperature control medium is normal.

In this case, whether the supply state of the temperature control medium is normal can be easily determined based on the temperature of the temperature control medium.

(Item 5) The processing liquid supply device according to any one of items 1 to 4, wherein the processor, by executing the program, may acquire, from a flow-rate sensor, a flow rate of the temperature control medium supplied by the chiller, and may determine, based on the acquired flow rate of the temperature control medium, whether the supply state of the temperature control medium is normal.

In this case, whether the supply state of the temperature control medium is normal can be easily determined based on the flow rate of the temperature control medium.

(Item 6) The processing liquid supply device according to any one of items 1 to 5, wherein the processor, by executing the program, in a case in which the supply state of the temperature control medium is abnormal, may output a warning signal indicating an abnormality in the supply state of the temperature control medium.

In this case, the user can easily identify whether the supply state of the temperature control medium is abnormal.

(Item 7) A substrate processing apparatus according to item 7 includes the processing liquid supply device according to any one of items 1 to 6, and a chamber in which the substrate is processed using the processing liquid supplied by the processing liquid supply device.

In this substrate processing apparatus, the substrate is processed in the chamber using the processing liquid supplied by the processing liquid supply device. In the processing liquid supply device, even in a case in which the supply state of the temperature control medium is abnormal, after the abnormal supply state of the temperature control medium is resolved, the heat exchange between the processing liquid and the temperature control medium can be easily resumed by opening the supply valve without requiring manpower and time for restoration. This enables easy restoration after resolution of the abnormality of the supply state of the temperature control medium.

(Item 8) A processing liquid supply method according to item 8 of supplying a processing liquid for substrate processing, with the processing liquid supply method being used when a chiller having an outlet and inlet for a temperature control medium is used in the substrate processing, wherein a sending pipe connects, to the outlet of the chiller, one end portion of a heat exchanger that exchanges heat between the processing liquid and the temperature control medium, a return pipe connects another end portion of the heat exchanger to the inlet of the chiller, a bypass pipe connects a first portion in the sending pipe to a second portion in the return pipe, with the first portion being located farther upstream than a portion connected to the heat exchanger, and with the second portion being located farther downstream than a portion connected to the heat exchanger, and a processor, by executing a program, determines whether a supply state of the temperature control medium supplied by the chiller is normal, in a case in which the supply state of the temperature control medium is normal, maintains supply of the temperature control medium to the heat exchanger by opening a supply valve, and in a case in which the supply state of the temperature control medium is abnormal, stops the supply of the temperature control medium to the heat exchanger by closing the supply valve.

With this processing liquid supply method, even in a case in which the supply state of the temperature control medium is abnormal, after the abnormal supply state of the temperature control medium is resolved, the heat exchange between the processing liquid and the temperature control medium can be easily resumed by opening the supply valve without requiring manpower and time for restoration. This enables easy restoration after resolution of the abnormality of the supply state of the temperature control medium.

(Item 9) A substrate processing method according to a ninth item includes the processing liquid supply method according to item 8, wherein the substrate is processed in a chamber using the processing liquid that is supplied using the processing liquid supply method.

With this substrate processing method, the substrate is processed in the chamber using the processing liquid supplied using the processing liquid supply method. With the processing liquid supply method, even in a case in which the supply state of the temperature control medium is abnormal, after the abnormal supply state of the temperature control medium is resolved, the heat exchange between the processing liquid and the temperature control medium can be easily resumed by opening the supply valve without requiring manpower and time for restoration. This enables easy restoration after resolution of the abnormality of the supply state of the temperature control medium.

While preferred embodiments of the present disclosure have been described above, it is to be understood that variations and modifications will be apparent to those skilled in the art without departing the scope and spirit of the present disclosure. The scope of the present disclosure, therefore, is to be determined solely by the following claims.

## Claims

1. A processing liquid supply device that is used together with a chiller and supplies a processing liquid for processing a substrate, the chiller having an outlet and an inlet for a temperature control medium, comprising:
a heat exchanger that has one end portion and another end portion, and exchanges heat between the processing liquid and the temperature control medium;
a sending pipe that connects the outlet of the chiller to the one end portion of the heat exchanger;
a return pipe that connects the inlet of the chiller to the another end portion of the heat exchanger;
a bypass pipe that connects a first portion in the sending pipe to a second portion in the return pipe, the first portion being located farther upstream than a portion connected to the heat exchanger, the second portion being located farther downstream than a portion connected to the heat exchanger;
a supply valve; and
a processor, wherein
the processor, by executing a program,
determines whether a supply state of the temperature control medium supplied by the chiller is normal,
in a case in which the supply state of the temperature control medium is normal, maintains supply of the temperature control medium to the heat exchanger by opening the supply valve, and
in a case in which the supply state of the temperature control medium is abnormal, stops the supply of the temperature control medium to the heat exchanger by closing the supply valve.

2. The processing liquid supply device according to claim 1, wherein
the supply valve is provided in a portion farther downstream than the first portion in the sending pipe.

3. The processing liquid supply device according to claim 1 or 2, further comprising a bypass valve provided in the bypass pipe, wherein
the processor, by executing the program,
in a case in which the supply state of the temperature control medium is normal, closes the bypass valve, and
in a case in which the supply state of the temperature control medium is abnormal, opens the bypass valve.

4. The processing liquid supply device according to any one of claims 1 to 3, wherein
the processor, by executing the program,
acquires, from a temperature sensor, a temperature of the temperature control medium supplied by the chiller, and
determines, based on the acquired temperature of the temperature control medium, whether the supply state of the temperature control medium is normal.

5. The processing liquid supply device according to any one of claims 1 to 4, wherein
the processor, by executing the program,
acquires, from a flow-rate sensor, a flow rate of the temperature control medium supplied by the chiller, and
determines, based on the acquired flow rate of the temperature control medium, whether the supply state of the temperature control medium is normal.

6. The processing liquid supply device according to any one of claims 1 to 5, wherein
the processor, by executing the program,
in a case in which the supply state of the temperature control medium is abnormal, outputs a warning signal indicating an abnormality in the supply state of the temperature control medium.

7. A substrate processing apparatus comprising:
the processing liquid supply device according to any one of claims 1 to 6; and
a chamber in which the substrate is processed using the processing liquid supplied by the processing liquid supply device.

8. A processing liquid supply method of supplying a processing liquid for substrate processing, the processing liquid supply method being used when a chiller having an outlet and inlet for a temperature control medium is used in the substrate processing, wherein
a sending pipe connects, to the outlet of the chiller, one end portion of a heat exchanger that exchanges heat between the processing liquid and the temperature control medium,
a return pipe connects another end portion of the heat exchanger to the inlet of the chiller,
a bypass pipe connects a first portion in the sending pipe to a second portion in the return pipe, with the first portion being located farther upstream than a portion connected to the heat exchanger, and with the second portion being located farther downstream than a portion connected to the heat exchanger, and
a processor, by executing a program,
determines whether a supply state of the temperature control medium supplied by the chiller is normal,
in a case in which the supply state of the temperature control medium is normal, maintains supply of the temperature control medium to the heat exchanger by opening a supply valve, and
in a case in which the supply state of the temperature control medium is abnormal, stops the supply of the temperature control medium to the heat exchanger by closing the supply valve.

9. A substrate processing method including the processing liquid supply method according to claim 8, wherein
the substrate is processed in a chamber using the processing liquid that is supplied using the processing liquid supply method.
